# EUROPÄISCHE PATENTANMELDUNG

(11) **EP 2 113 945 A1**
(43) Veröffentlichungstag der Anmeldung: **04.11.2009**
(21) Anmeldenummer: 08405123.4
(22) Anmeldetag: 30.04.2008
(51) Int. Cl.: H01L 31/02, H01L 31/048

(54) **Verfahren zur Herstellung einer Kontaktierung von Solarzellen**

(71) Anmelder: 3S Swiss Solar Systems AG, 3250 Lyss (CH); Güdel Group AG, 4900 Langenthal (CH)
(72) Erfinder: Blanchet, Marcel, CH-8172 Niederglatt (CH); Kappaun, Roland, DE-88690 Uhldingen-Mühlhofen (DE); Zulauf, Walter, CH-4932 Gutenberg (CH); Kurt, Hans-Ulrich, CH-4566 Kriegstetten (CH); Güdel, Rudolf, CH-4500 Solothum (CH); Heid, Rudolf, CH-4542 Luterbach (CH)
(74) Vertreter: Rüfenacht, Philipp Michael

(57) **Zusammenfassung**

Bei einem Verfahren zur Herstellung einer Kontaktierung von in einem laminierten Solarpanel (1) angeordneten Solarzellen (30), wobei die Solarzellen (30) beidseitig ihrer Hauptflächen von je mindestens einer Schicht überdeckt sind, werden vor einem Laminationsschritt die Solarzellen (30) durch elektrisch leitende Verbinder (31, 33) verbunden, wobei die elektrisch leitenden Verbinder (31, 33) derart in das zu laminierende Solarpanel eingebracht werden, dass sie nach dem Laminationsschritt vollständig im Solarpanel (1) einlaminiert sind. Nach dem Laminationsschritt wird ein Kontaktbereich (35) der elektrisch leitenden Verbinder (33) freigelegt, indem mindestens eine der die Solarzellen überdeckenden Schichten in einem entsprechenden Bereich vollständig durchstossen, insbesondere abgetragen, wird. Anschliessend kann der Kontaktbereich (35) der elektrisch leitenden Verbinder (33) mittels eines von aussen abgreifbaren Anschlusselements kontaktiert werden. Indem vor der Lamination keine aufwändigen Durchführungen geschaffen und die elektrischen Verbinder (31, 33) im Wesentlichen flach in die entsprechende Ebene des Schichtsystems verlegt werden können, lässt sich das Verlegen der Verbinder (31, 33) automatisieren. Die Position der elektrischen Verbinder (31, 33) innerhalb des Schichtsystems lässt sich zudem genauer vorgeben als die Position von aus dem Schichtsystem ragenden Verbinderenden, was das Kontaktieren des Kontaktbereichs (35) der Verbinder (31, 33), insbesondere bei einer automatisierten Lösung, erheblich vereinfacht.

## Beschreibung

### Technisches Gebiet

Die Erfindung betrifft ein Verfahren zur Herstellung einer Kontaktierung von in einem laminierten Solarpanel angeordneten Solarzellen, wobei die Solarzellen beidseitig ihrer Hauptflächen von je mindestens einer Schicht überdeckt sind. Die Erfindung betrifft weiter ein Verfahren zur Herstellung von Solarpanels, ein Solarpanel sowie eine Anlage zur Herstellung von laminierten Solarpanels.

### Stand der Technik

Es ist bekannt, Solarpanels (auch Solarmodule genannt) aufzubauen, indem eine Mehrzahl von mechanisch empfindlichen Solarzellen (photovoltaische Zellen, z. B. Dickschicht-Solarzellen auf der Basis von Silicium) elektrisch miteinander verbunden und in einem Schichtsystem eingeschlossen werden. Das Schichtsystem verleiht mechanische Stabilität und schützt die eingeschlossenen Zellen vor Witterungseinflüssen oder mechanischen Beeinträchtigungen. Das Schichtsystem kann beispielsweise auf einem für die relevanten Anteile der Sonnenstrahlung transparenten Glassubstrat und einer Rückseitenfolie basieren, zwischen welchen die Solarzellen und die sie verbindenden elektrischen Verbinder eingeschlossen sind. Zwischen den genannten Schichten sind Folien aus EVA (Ethylenvinylacetat) oder einem anderen geeigneten Material eingebracht, so dass das Schichtsystem unter dem Einfluss von Wärme und Druck zusammenlaminiert werden kann. Die Solarzellen können von einem Rahmen umschlossen werden.

Ein Solarpanel umfasst elektrische Anschlüsse, mit welchen die innerhalb des Schichtsystems elektrisch miteinander verbundenen Solarzellen von aussen kontaktierbar sind. In der Regel sind mehrere (oder alle) der in einem Modul umfassten Solarzellen in Serie geschaltet, um ausreichende Ausgangsspannungen zu ermöglichen. Ein Solarmodul umfasst zudem oft mehrere Kreise, die einzeln abgreifbar sind, so dass auch bei einer teilweisen Beschattung des Moduls noch Strom bezogen werden kann. Anstelle von zwei Anschlüssen (je einer pro Polarität) sind somit drei, vier oder noch mehr Anschlüsse vorhanden.

Bei bekannten Herstellungsverfahren für Solarpanels wurden zur Schaffung der elektrischen Anschlüsse vor der Lamination des Schichtsystems einige der elektrischen Verbinder durch die Rückseitenfolie hindurch auf die Aussenseite geführt. Nach der Lamination konnten dann Anschlusselemente wie Buchsen oder Stecker mit diesen nach aussen geführten Anschlussfahnen verbunden werden, z. B. durch Löten.

Die Schritte der Herstellung der Durchführung für die Verbinder und der Anbringung der Anschlusselemente sind praktisch nur manuell durchführbar. Die nach aussen geführten Verbinder haben keine klar festgelegte Position und erschweren das Handling des herzustellenden Solarpanels. Bei der Automatisierung stellen sich entsprechend erhebliche Schwierigkeiten, und der bisherige Prozess ist fehleranfällig. Deshalb ist der gesamte Herstellungsprozess für die Solarpanels teuer und kompliziert.

### Darstellung der Erfindung

Aufgabe der Erfindung ist es, ein dem eingangs genannten technischen Gebiet zugehörendes Verfahren zur Herstellung einer Kontaktierung von Solarzellen zu schaffen, welches (möglichst durchgehend) automatisierbar ist und eine geringere Fehleranfälligkeit aufweist.

Die Lösung der Aufgabe ist durch die Merkmale des Anspruchs 1 definiert. Gemäss der Erfindung werden im Rahmen des Verfahrens folgende Schritte ausgeführt: Vor einem im Rahmen der Herstellung des Solarpanels erfolgenden Laminationsschritt werden die Solarzellen durch elektrisch leitende Verbinder verbunden, wobei die elektrisch leitenden Verbinder derart in das zu laminierende Solarpanel eingebracht werden, dass sie nach dem Laminationsschritt vollständig im Solarpanel einlaminiert sind. Nach dem Laminationsschritt wird ein Kontaktbereich der elektrisch leitenden Verbinder freigelegt, indem mindestens eine der die Solarzellen überdeckenden Schichten in einem entsprechenden Bereich vollständig durchstossen, insbesondere abgetragen, wird. Anschliessend wird der Kontaktbereich der elektrisch leitenden Verbinder mittels eines von aussen abgreifbaren Anschlusselements kontaktiert.

Der Kontaktbereich der Verbinder wird also zunächst einlaminiert und ist nach der Lamination vollständig von den umgebenen Schichten umschlossen. Nach der Lamination wird dann der Kontaktbereich wieder freigelegt. Je nach Anzahl Kreise sind pro Solarpanel zwei oder mehrere Kontaktbereiche vorhanden.

Indem vor der Lamination keine aufwändigen Durchführungen geschaffen werden müssen und die elektrischen Verbinder im Wesentlichen flach in die entsprechende Ebene des Schichtsystems verlegt werden können, lässt sich das Verlegen der Verbinder automatisieren. Die Geometrie der Verbinder lässt sich zudem vereinfachen. Da für die nachfolgenden Verfahrensschritte, insbesondere für das Laminieren, keine Durchgänge durch einzelne Schichten des Schichtsystems vorhanden sind und da keine Verbinder aus dem Schichtsystem herausragen, lässt sich das Schichtsystem in diesen nachfolgenden Verfahrensschritten einfacher handhaben. Die Position der elektrischen Verbinder innerhalb des Schichtsystems lässt sich zudem genauer vorgeben als die Position von aus dem Schichtsystem ragenden Verbinderenden, was das Kontaktieren des Kontaktbereichs der Verbinder, insbesondere bei einer automatisierten Lösung, erheblich vereinfacht.

Ein mit dem erfindungsgemässen Verfahren hergestelltes Solarpanel umfasst also mindestens zwei Schichten, welche eine Mehrzahl von Solarzellen beidseitig ihrer Hauptflächen einschliessen und ist wie folgt aufgebaut:
a) Die Schichten und die Solarzellen sind zusammenlaminiert;
b) die Solarzellen sind durch vollständig innerhalb der Schichten befindliche elektrisch leitende Verbinder miteinander verbunden;
c) die elektrisch leitenden Verbinder umfassen einen innerhalb der Schichten befindlichen Kontaktbereich;
d) ein Zugang zum Kontaktbereich ist vorhanden, welcher mindestens eine den Kontaktbereich überdeckende Schicht durchquert; und
e) ein von aussen abgreifbares Anschlusselement ist durch den Zugang geführt und im Kontaktbereich des Verbinders mit diesem elektrisch verbunden, insbesondere verschweisst oder verlötet.

Ein solches Panel kann durch ein Verfahren mit folgenden Schritten hergestellt werden:
a) Bereitstellen eines Grundsubstrats, insbesondere einer Glasplatte;
b) Aufbringen einer ersten Laminierfolie auf das Grundsubstrat, insbesondere einer Folie aus EVA;
c) Verbinden einer Mehrzahl von Solarzellen mittels elektrisch leitenden Verbindern;
d) Aufbringen der Solarzellen auf die erste Laminierfolie;
e) Aufbringen einer zweiten Laminierfolie auf die Solarzellen, insbesondere einer Folie aus EVA;
f) Aufbringen einer Rückseitenschicht auf die zweite Laminierfolie zur Herstellung des noch unlaminierten Solarpanels;
g) Laminieren der unlaminierten Solarpanels;
h) Freilegen eines Kontaktbereichs der elektrisch leitenden Verbinder, indem die Rückseitenschicht und die aus der zweiten Laminierfolie entstandene Verbindungsschicht in einem entsprechenden Bereich vollständig durchstossen, insbesondere abgetragen, wird; und
i) Kontaktieren des Kontaktbereichs der elektrisch leitenden Verbinder mittels eines von aussen abgreifbaren Anschlusselements.

Dabei bildet das Grundsubstrat während der Bearbeitung bevorzugt die unterste Schicht, es ist aber im Rahmen der Erfindung auch denkbar, umgekehrt zu arbeiten, d. h. das Grundsubstrat als oberste Schicht vorzusehen, oder das teilweise aufgebaute Schichtsystem während der Bearbeitung einmal oder mehrere Male zu drehen. Die Reihenfolge des elektrischen Verbindens der Solarzellen (Schritt c) und des Aufbringens der Solarzellen auf die erste Laminierfolie (Schritt d) kann nach Belieben gewählt werden.

Eine geeignete Anlage umfasst
a) eine Station zum Verbinden von Solarzellen durch elektrisch leitende Verbinder;
b) eine Station zum Aufbauen des zu laminierenden Solarpanels, wobei die Solarzellen und die elektrisch leitenden Verbinder beidseitig ihrer Hauptflächen von je mindestens einer Schicht überdeckt werden;
c) eine Einrichtung zum Laminieren des Solarpanels;
d) eine Einrichtung, insbesondere eine Fräsmaschine, zum Freilegen eines Kontaktbereichs der im Solarpanel einlaminierten elektrischen Verbinder, indem mindestens eine der die Solarzellen überdeckenden Schichten in einem entsprechenden Bereich vollständig durchstossen, insbesondere abgetragen, wird; und
e) eine Einrichtung, insbesondere eine Löt- oder Schweissstation, zum Kontaktieren des Kontaktbereichs der elektrisch leitenden Verbinder mittels eines von aussen abgreifbaren Anschlusselements.

Die erwähnten Stationen und Einrichtungen funktionieren mit Vorteil vollautomatisch. Es sind aber auch Ausführungsformen denkbar, bei welchen einzelne der Stationen bzw. Einrichtungen halbautomatisch oder manuell realisiert sind.

Das Freilegen des Kontaktbereichs erfolgt also mit Vorteil durch Fräsen. Ein derartiger Bearbeitungsschritt lässt sich gut automatisieren, ermöglicht eine hohe Präzision und eine schonende Bearbeitung der betroffenen Schichten des laminierten Schichtsystems sowie der elektrischen Verbinder. Durch das Freifräsen wird zudem im Kontaktbereich des Verbinders eine saubere Oberfläche für den nachfolgenden Verbindungsprozess geschaffen. Beim Fräsen wird die Bearbeitungsstelle mit Vorteil durch Luft gekühlt, zudem werden die entstehenden Späne abgesaugt. Der Fräser ist vorteilhaft so gestaltet, dass die Späne möglichst kurz werden.

Andere Bearbeitungsarten, z. B. Schneiden, Stanzen oder Aufschmelzen, sind grundsätzlich auch denkbar.

Mit Vorteil wird vor dem Freilegen des Kontaktbereichs eine Position der elektrisch leitenden Verbinder, insbesondere eine Lage und eine Tiefe, gemessen. Dazu ist bei einer entsprechenden Anlage im Ablauf vor der Einrichtung zum Freilegen des Kontaktbereichs bevorzugt eine Einrichtung zum Messen einer Position der elektrisch leitenden Verbinder angeordnet. Die vorgängige Positionsmessung ermöglicht ein präzises Freilegen und eine sichere Kontaktierung des Kontaktbereichs. Sie ist vor allem deshalb angezeigt, weil bei gängigen Laminaten die vollständig einlaminierten Verbinder in der angrenzenden Laminierfolienschicht "schwimmen" und somit während des Laminationsprozesses ihre Position nicht genau beibehalten. Die Bestimmung der Lage ermöglicht eine präzise Positionierung des Bearbeitungswerkzeugs zum Freilegen des Kontaktbereichs, die Bestimmung der Tiefe ermöglicht die Einstellung einer präzisen Bearbeitungstiefe und stellt somit sicher, dass der Kontaktbereich tatsächlich freigelegt wird, dass aber gleichzeitig keine Beschädigung bzw. übermässige Beeinträchtigung der elektrisch leitenden Verbinder erfolgt.

Das Fräsen kann mittels eines handelsüblichen computergesteuerten Fräskopfs erfolgen. Der Detektor für die Lage der Kontaktbereiche und das Fräswerkzeug sind mit Vorteil am gleichen Kopf angebracht, wodurch sich ein einfacher Aufbau und eine hohe Bearbeitungspräzision erreichen lässt. Zunächst werden die zu bearbeitenden Frässtellen vermessen, dann erfolgt das Fräsen. Falls mehrere Kontaktbereiche mit Kontaktelementen zu kontaktieren sind, die eine fest vorgegebene relative Zuordnung (Layout) aufweisen, werden anschliessend anhand der gemessenen Werte die individuellen Frästiefen sowie eine einzige Lage des Layouts der Kontaktstellen eingestellt.

Die Messung der Position der elektrisch leitenden Verbinder wird vorzugsweise mittels eines induktiven Sensors vorgenommen. Ein solcher Sensor ist verhältnismässig kostengünstig, es hat sich zudem gezeigt, dass mit einem solchen sowohl die seitliche Position der einlaminierten Verbinder als auch deren Tiefe in einem Arbeitsgang präzise festgestellt werden kann, wobei die Ergebnisse von den umgebenden Schichten der Schichtenfolge nicht störend beeinflusst werden. Ein im Handel erhältlicher induktiver Sensor mit analogem Stromausgang wird beispielsweise über die ungefähr erwartete Position der Kontaktbereiche der elektrisch leitenden Verbinder verfahren. Die seitliche Lage des Verbinders lässt sich dann durch Detektion des minimalen Stroms ermitteln, die Tiefe durch den Absolutwert des minimalen Stroms.

Es sind auch Sensoren denkbar, die auf einem anderen Prinzip basieren, z. B. Ultraschall-oder Röntgensensoren bzw. mechanische (Tast-)Sensoren. Kapazitive Sensoren erscheinen wenig geeignet, da die Messergebnisse massgeblich von den Eigenschaften der umgebenden Schichten beeinflusst werden.

Die elektrisch leitenden Verbinder können vor dem Laminationsschritt in ihrem Kontaktbereich mit einer Materialverstärkung versehen werden, d. h. im Kontaktbereich wird die Materialmenge erhöht. Auch bei einem Freilegungsverfahren, bei welchem das Material des Verbinders teilweise abgetragen wird, um eine zuverlässige Kontaktierung zu gewährleisten (z. B. bei einem Fräsverfahren) ist so sichergestellt, dass der verbleibende Querschnitt des Verbinders für die zu leitenden Ströme ausreicht. Die Materialverstärkung kann beispielsweise durch eine Dopplung des Verbinders erreicht werden (insbesondere wenn der Verbinder bandartig ausgebildet ist), d. h. ein freies Ende des Verbinders wird umgelegt, um den Materialquerschnitt zu verdoppeln; anschliessend wird der umgelegte Abschnitt bevorzugt mit dem darunter- bzw. darüberliegenden Abschnitt verbunden, z. B. verlötet. Anstelle einer Dopplung kann auch ein anderes Verfahren der Materialanhäufung, z. B. Stauchen, angewandt werden oder es wird ein Zusatzelement verwendet.

Die Materialverstärkung wird mit Vorteil bereits vor dem Verbinden der Solarzellen hergestellt, d. h. diejenigen Verbinder, die eine Verstärkung benötigen, werden bereits vorkonfektioniert. Dadurch kann der Bearbeitungsprozess einfach gehalten werden.

Alternativ erfolgt die Verstärkung, z. B. das Umlegen zur Herstellung einer Dopplung, erst nach dem Verbinden der Solarzellen.

Anstelle einer Materialverstärkung kann beispielsweise der Querschnitt des elektrischen Verbinders durchgängig vergrössert werden, oder es wird ein Verfahren zum Freilegen verwendet, bei welchem der Querschnitt nicht verringert wird.

Die elektrisch leitenden Verbinder werden vorteilhaft derart angeordnet, dass alle Kontaktbereiche in einem Randbereich des Solarpanels und insbesondere benachbart zueinander zu liegen kommen. Dadurch wird ein einfacheres Layout der Verbinder ermöglicht, zudem kann im Bereich der Verbindung auf eine zusätzliche Isolation gegenüber darunterliegenden Solarzellen verzichtet werden. Es besteht zudem nicht die Gefahr, dass beim Freilegen der Kontaktbereiche durch mechanische und/oder thermische Einflüsse Solarzellen beschädigt werden könnten.

Alternativ erfolgt die Verbindung im Bereich der Solarzellen. Dies bedingt eine zusätzliche Isolation und ein Verfahren zur Freilegung, bei welchem keine Gefahr der Beschädigung von Solarzellen besteht. Dafür kann das Verhältnis der Zellfläche zur Gesamtfläche vergrössert werden, was einen höheren Flächenwirkungsgrad ergibt.

Die im Randbereich befindlichen elektrisch leitenden Verbinder können im Bereich der Kontaktbereiche auf einem zusätzlichen gemeinsamen Träger angeordnet werden, d. h. auf einem Träger, der nicht Teil ist der Schichtenfolge und welcher nur im Bereich der Kontaktbereiche vorhanden ist. Geeignet als Träger ist beispielsweise ein Band aus Polyvinylfluorid (Tedlar). Der Träger und gegebenenfalls die im Bereich des Trägers anzuordnenden Verbinder mitsamt den Kontaktbereichen lassen sich vorkonfektionieren, was die Verarbeitung vereinfacht. Durch den Träger wird zudem eine Abtrennung der dahinter liegenden Verbinder von der Vorderseite des Solarpanels geschaffen, wodurch die Verbinder von allfälligen schädlichen Einflüssen, wie z. B. vor Sonnenstrahlung, geschützt werden und wodurch die Ästhetik des Solarpanels verbessert wird. Der Träger schafft zudem eine thermische Barriere gegen die davorliegende Schicht und verhindert so eine Beschädigung derselben, wenn das Anschlusselement z. B. durch Schweissen oder Löten mit dem Kontaktbereich der elektrisch leitenden Verbinder verbunden wird.

Alternativ sind die Verbinder nur auf den umliegenden Schichten aufgelegt.

Die Solarzellen werden bevorzugt mittels Längsverbindern miteinander zu Strängen verbunden, und verschiedene der Stränge werden mittels Querverbinder elektrisch verbunden, wobei die Kontaktbereiche an den Querverbindern ausgebildet sind. Dadurch wird ein einfaches Layout erreicht. Ein besonders einfaches Layout ergibt sich, wenn sowohl die Längs- als auch die Querverbinder gerade ausgeführt sind und rechtwinklig zueinander angeordnet werden. Aufgrund der zu leitenden Ströme weisen die Querverbinder einen grösseren Querschnitt auf als die Längsverbinder. An den Querverbindern lassen sich deshalb sichere und langlebige Kontaktbereiche einfacher ausführen als an den vergleichweise dünnen Längsverbindern. Insbesondere die Querverbinder können im Randbereich des Solarpanels und gegebenenfalls auf einem zusätzlichen Träger angeordnet sein.

Alternativ können andere Layouts verwendet werden.

Das Verbinden der Mehrzahl von Solarzellen mittels elektrisch leitenden Verbindern erfolgt mit Vorteil vor dem Aufbringen der Solarzellen auf die erste Laminierfolie. Dies stellt sicher, dass durch das Verbinden (insbesondere durch Löten) keine Beeinträchtigung der Laminierfolie erfolgt. Bereits vor dem Auflegen können die hergestellten Stränge und/oder die gesamten Layouts zudem elektrisch geprüft werden, z. B. durch eine sogenannte Dunkelstromprüfung.

Das Verbinden der Längsverbinder mit dem Querverbinder bzw. den Querverbindern und/oder das Kontaktieren des Kontaktbereichs der elektrisch leitenden Verbinder durch das von aussen abgreifbare Anschlusselement erfolgt vorzugsweise durch eine fluxfreie Verbindung. Übliche Flussmittel dampfen aus und reagieren mit dem Material der Laminierfolien (also z. B. EVA), wodurch die Betriebstemperatur für den Polymerisationsprozess nach oben begrenzt wird. Entsprechend der niedrigeren Betriebstemperatur sind längere Laminationszeiten erforderlich. Wenn auf Flussmittel verzichtet werden kann, z. B. indem ein Verfahren zum Drahtbonden (wire bonding) eingesetzt wird und entsprechend die Reaktion mit dem Laminiermaterial unterbleibt, lässt sich die Wirtschaftlichkeit des Verfahrens aufgrund deutlich geringerer Laminationszeiten erheblich steigern.

Das von aussen abgreifbare Anschlusselement ist vorteilhaft in einer Anschlussdose angeordnet, wobei die Anschlussdose zum Kontaktieren des Kontaktbereichs der elektrisch leitenden Verbinder mit einer ersten Hauptfläche auf eine Rückseite des laminierten Solarpanels aufgebracht wird. Die Anschlussdose schützt die Kontaktstellen mit den elektrischen Verbindern und stellt eine stabile und dauerhafte Anschlussmöglichkeit bereit.

Das Anschlusselement ist im Rahmen einer bevorzugten Ausführungsform mit einem ersten Ende an der Anschlussdose (mechanisch) befestigt und mit seinem zweiten, freien Ende federnd ausgeführt, so dass das federnde Ende nach dem Aufbringen der Anschlussdose den Kontaktbereich kontaktiert. Anschliessend kann das federnde Ende mit dem Kontaktbereich verbunden, insbesondere verschweisst oder verlötet, werden. Die federnde Ausgestaltung der Anschlusselemente stellt einen Toleranzausgleich zwischen den Anschlusselementen und den entsprechenden Kontaktbereichen sicher.

Das Anschlusselement ist bevorzugt im Bereich einer von der ersten Hauptfläche bis zur Rückseite der Anschlussdose durchgehenden Öffnung angeordnet, so dass zum Verbinden des Anschlusselements mit dem Kontaktbereich ein Verbindungswerkzeug von einer Rückseite an das Anschlusselement herangeführt werden kann. Weil auch nach dem Aufsetzen der Anschlussdose der Kontaktbereich direkt von hinten zugänglich bleibt, wird eine Automatisierung des Verbindungsschritts stark vereinfacht. Nach dem Aufsetzen der Dose und dem Verbinden des freien Endes wird die Öffnung bevorzugt mit dem Kontaktbereich vergossen. Durch das Vergiessen wird eine Immobilisation der miteinander verbundenen Elemente und ein langfristiger Schutz der Kontaktstellen erreicht.

Die elektrisch leitenden Verbinder sind mit Vorteil zumindest im Kontaktbereich bandartig, wobei sie im Wesentlichen flach zwischen die Schichten des Solarpanels eingebracht werden, d. h. die Hauptflächen der bandartigen Verbinder sind parallel mit den Hauptflächen der einzelnen Schichten der Schichtfolge. Mit bandartigen Verbindern lassen sich für die zu leitenden Ströme ausreichende Querschnitte erreichen, während gleichzeitig vermieden wird, dass die Verbinder zu stark auftragen und beispielsweise die gleichmässige Lamination des Schichtsystems beeinträchtigen können.

Aus der nachfolgenden Detailbeschreibung und der Gesamtheit der Patentansprüche ergeben sich weitere vorteilhafte Ausführungsformen und Merkmalskombinationen der Erfindung.

### Kurze Beschreibung der Zeichnungen

### Die zur Erläuterung des Ausführungsbeispiels verwendeten Zeichnungen zeigen:

- Fig. 1: eine schematische Darstellung einer Aufsicht auf ein erfindungsgemässes Solarpanel;
- Fig. 2: eine schematische Darstellung eines Querschnitts durch das Solarpanel;
- Fig. 3: eine schematische Querschnittsdarstellung der Ermittlung der Lage eines Kontaktbereichs;
- Fig. 4: eine schematische Querschnittsdarstellung der Freilegung eines Kontaktbereichs;
- Fig. 5: eine schematische Querschnittsdarstellung eines freigelegten Kontaktbereichs;
- Fig. 6: eine schematische Querschnittsdarstellung der Kontaktierung des Kontaktbereichs;
- Fig. 7: eine schematische Draufsicht auf die Rückseite des Solarpanels und der Anschlussdose; und
- Fig. 8: eine Blockdarstellung einer erfindungsgemässen Anlage zur Herstellung von Solarpanels.

Grundsätzlich sind in den Figuren gleiche Teile mit gleichen Bezugszeichen versehen.

### Wege zur Ausführung der Erfindung

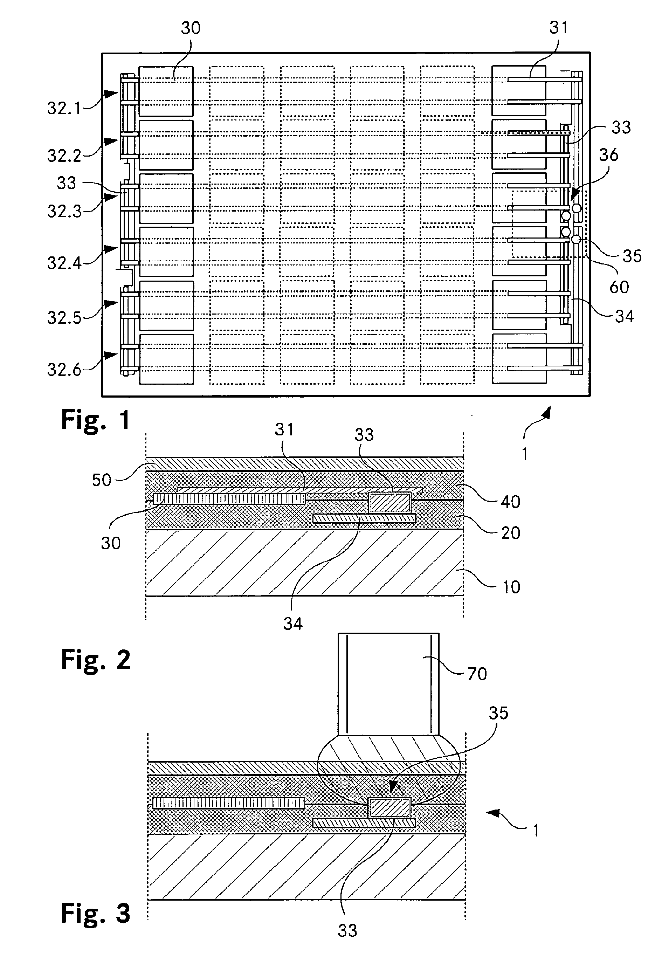

Die Figur 1 zeigt eine schematische Darstellung einer Aufsicht auf ein erfindungsgemässes Solarpanel. Die Figur 2 ist eine schematische Darstellung eines Querschnitts durch das Solarpanel. Das Solarpanel 1 umfasst als Grundsubstrat eine Glasplatte 10 aus Einscheiben-Sicherheitsglas. Auf dieser ist ein Schichtsystem aus einer ersten transparenten Kunststoffschicht 20 aus Ethylenvinylacetat (EVA), einer Mehrzahl von an sich bekannten Solarzellen 30, einer zweiten Kunststoffschicht 40 aus Ethylenvinylacetat (EVA) sowie einer Rückseitenfolie 50 aus Polyester aufgebaut. Das Solarpanel 1 wird derart angeordnet (z. B. auf einem Gebäudedach befestigt), dass die Glasplatte 10 der Sonne zugewandt ist. Die Sonnenstrahlung tritt durch die Glasplatte 10 sowie die erste transparente Kunststoffschicht 20 hindurch und trifft auf die zwischen den Kunststoffschichten 20, 40 eingebetteten Solarzellen 30, wo eine elektrische Spannung erzeugt wird.

Jeweils mehrere der Solarzellen 30 (im dargestellten Beispiel je sechs) sind durch Längsverbinder 31 zu mehreren (im dargestellten Beispiel sechs) Strängen 32.1...32.6 in Serie verbunden. Die entsprechenden Verbindungen sind in der Figur 1 zum Teil nur andeutungsweise dargestellt (gestrichelte Linien). Die Längsverbinder 31 sind dazu mit Kontaktflächen der Solarzellen 30 verlötet. Je zwei der Stränge 32.1, 32.2 bzw. 32.3, 32.4 bzw. 32.5, 32.6 sind wiederum in Serie miteinander verbunden, wobei die Verbindung durch Querverbinder 33 geschaffen wird. Die in der Figur 1 dargestellte Schaltung weist vier Abgriffe auf (siehe unten), wobei die zwei ersten zusammengeschalteten Stränge 32.1, 32.2 zwischen einem ersten und einem zweiten Abgriff, der dritte und vierte miteinander zusammengeschaltete Strang 32.3, 32.4 zwischen dem zweiten und einem dritten Abgriff und der fünfte und sechste miteinander zusammengeschaltete Strang 32.5, 32.6 zwischen dem dritten und einem vierten Abgriff geschaltet sind. Es lassen sich somit gezielt sämtliche Solarzellen 30 oder einzelne Bereiche des Solarpanels 1 abgreifen.

Bei den erwähnten Querverbindern 33 handelt es sich um verzinnte 5x0.4mm-Kupferbänder. Die Zinnschicht hat dabei eine Dicke von ca. 20 µm. Der Querschnitt ist so gewählt, dass die zu erwartenden Maximalströme geleitet werden können. Die Querverbinder 33 sind in zwei gegenüberliegenden Randbereichen des Solarpanels 1 angeordnet und verlaufen im Wesentlichen senkrecht zu den Längsverbindern 30, wobei die Hauptflächen der Querverbinder 33 parallel liegen zu den Hauptflächen der einzelnen Schichten des Schichtsystems. Die Querverbinder 33 sind mittels einer Schicht aus EVA auf einem Trägerband 34 aus Polyvinylfluorid (Tedlar) aufgebracht. In einem der einander gegegenüberliegenden Randbereiche des Solarpanels umfasst jeder der vier, jeweils in einer Hälfte des Solarpanels 1 angeordneten Querverbinder 33 im Bereich eines freien Endes einen Kontaktbereich 35, wobei die Kontaktbereiche 35 die oben erwähnten Abgriffe bereitstellen und wobei sie einander benachbart derart angeordnet sind, dass die vier Kontaktbereiche 35 ein trapezförmiges Kontaktviereck 36 bilden. Die Solarzellen 30, die Längsverbinder 31 und die Trägerbänder 34 mit den Querverbindern 33 sind allesamt zwischen den beiden Kunststoffschichten 20, 40 eingeschlossen. Bei den Kontaktbereichen 35, d. h. an den entsprechenden freien Enden sind die Querverbinder 33 auf 12 mm Länge umgelegt und das umgelegte Ende ist verlötet, so dass der Querschnitt der Querverbinder 33 in den Kontaktbereichen verdoppelt ist.

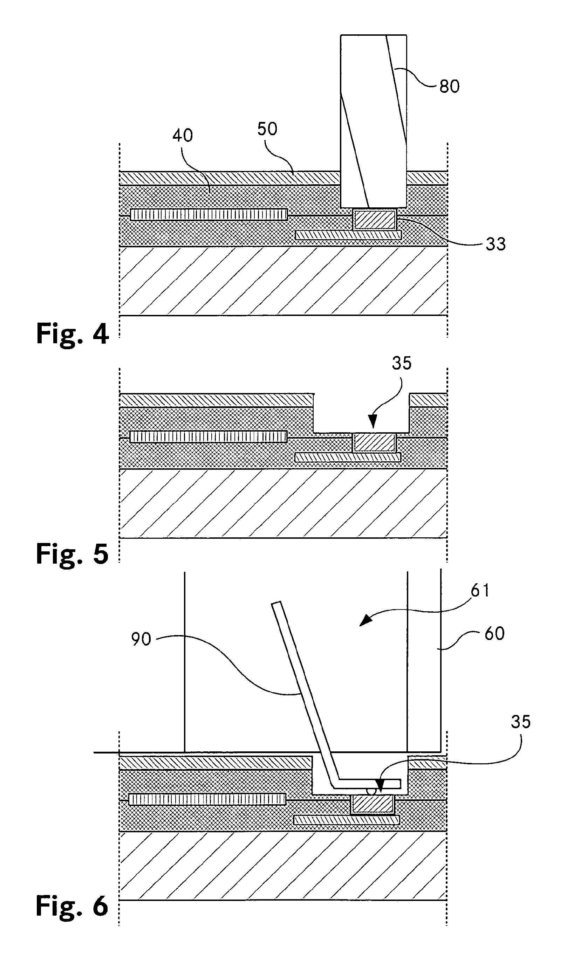

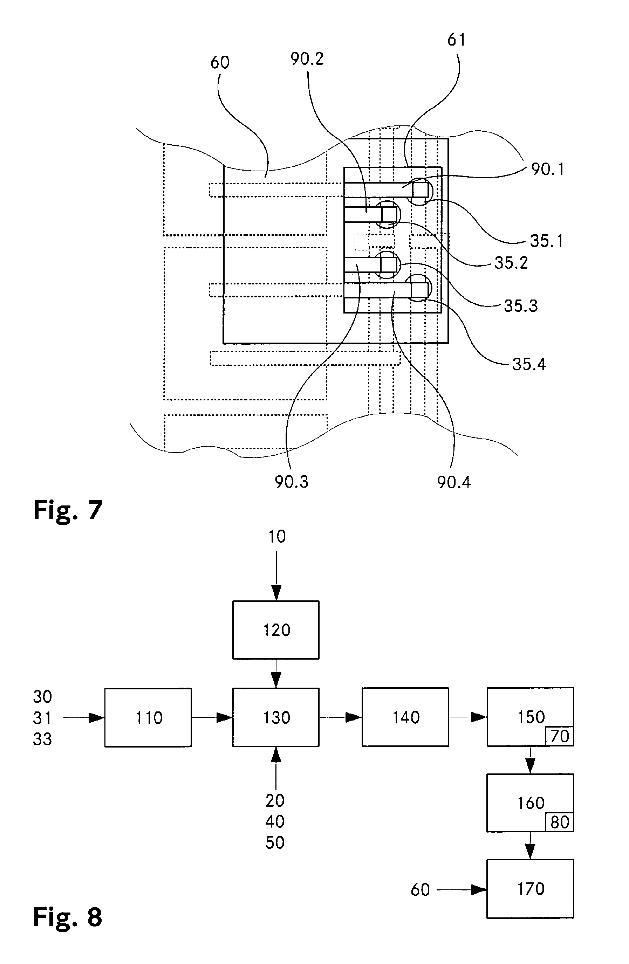

Auf die Rückseite des Solarpanels 1 wird eine Anschlussdose 60 gesetzt, welche Anschlusselemente aufweist, die mit den Kontaktbereichen 35 der Querverbinder 33 verbunden werden können (siehe unten, Fig. 6 und 7). In der Anschlussdose 60 sind Freilaufdioden angeordnet, welche in an sich bekannter Weise verhindern, dass die Ausgangsspannung zusammenbricht, wenn z. B. das Solarpanel teilweise abgeschattet wird, indem beschattete Bereiche gleichsam "ausgeblendet" werden. Das Solarpanel 1 kann zudem mit einem Rahmen, z. B. aus Aluminium, versehen werden (nicht dargestellt).

Im Folgenden wir die Herstellung des Solarpanels 1 beschrieben. Eine dazu geeignete Anlage ist in der Figur 8 in einer Blockdarstellung gezeigt. Zur Fertigung des Solarpanels 1 wird die Glasplatte 10 zunächst gereinigt und für die weiteren Verfahrensschritte vorbereitet (Station 120). In einer weiteren Station 110 werden die Solarzellen 30 zunächst mit den Längsverbindern 31 zu Strängen 32.1...32.6 verbunden, anschliessend werden die Stränge mittels der Querverbinder 33 zusammengeschaltet. Anschliessend wird in einer weiteren Station 130 das Schichtsystem schrittweise auf die Glasplatte 10 aufgelegt, d. h. eine erste Kunststofffolie aus EVA zur Bildung der ersten Kunststoffschicht 20, die zusammengeschalteten Solarzellen 30 mitsamt Längs- und Querverbindern 31, 33, eine zweite Kunststofffolie zur Bildung der zweiten Kunststoffschicht 40 und die Rückseitenfolie 50 werden auf die Glasplatte gelegt. Als nächstes erfolgt in einer Laminationseinrichtung 140 das Laminieren des Moduls bei Unterdruck und ca. 150°C. Beim Laminieren bilden sich aus den bis dahin milchigen EVA-Kunststofffolien klare, dreidimensional vernetzte und nicht mehr aufschmelzbare Kunststoffschichten 20, 40, in der die Solarzellen 30 und die Verbinder nun eingebettet sind und die fest untereinander sowie mit der Glasplatte 10 und der Rückseitenfolie 50 verbunden sind. Nach dem Laminieren werden die Kanten gesäumt, die Anschlussdose 60 wird gesetzt und mit den Freilaufdioden bestückt. Nun wird das Solarpanel 1 noch gerahmt, vermessen und nach seinen elektrischen Werten klassifiziert und verpackt.

Mit Bezug auf die Figuren 3 - 6 wird die erfindungsgemässe Kontaktierung der Kontaktbereiche der Querverbinder beschrieben. Die Figur 3 ist eine schematische Querschnittsdarstellung der Ermittlung der Lage eines Kontaktbereichs 35 in einer entsprechenden Messeinrichtung 150. Dazu wird ein induktiver Sensor 70, z. B. ein Analogsensor des Typs IWRM 12 der Firma Baumer Electric, Frauenfeld, Schweiz mit einer Messdistanz von 0 - 4 mm, über die Rückseite des bereits laminierten Solarpanels 1 geführt und der Ausgangsstrom an verschiedenen Positionen gemessen. Die Messeinrichtung besteht neben dem genannten Analogsensor aus einer Stromquelle (24 V Gleichstrom), einem passend gewählten Lastwiderstand und einem Multimeter, welches im resultierenden Ausgangsstrombereich (hier 4...20 mA) eine ausreichende Auflösung besitzt. Es hat sich herausgestellt, dass eine Entfernung des Sensors von der Rückseitenfolie von 1.6 mm gute Resultate liefert. Damit ein eindeutiger Bezug zwischen der Positionsmessung und dem nachfolgenden, weiter unten beschriebenen Fräsvorgang gewährleistet ist, ist der Sensor am Frässpindelsupport über einen Messuhrhalter befestigt, wobei der Sensor gegenüber der Fräserspitze um 1.0 mm zurückversetzt ist. Im beschriebenen Ausführungsbeispiel besteht nur die Notwendigkeit, die seitliche Position der Querverbinder 33 zu bestimmen, da eine Längsverschiebung, entlang der Ausdehnung der Querverbinder 33, unkritisch ist.

Wird der Sensor 70 quer zum Querverbinder 33 geführt, entspricht die Position, an welcher ein minimaler Ausgangsstrom gemessen wird, der Mitte des Querverbinders 33. Aus dem Absolutwert des minimalen Ausgangsstroms kann zudem auf die Tiefe des Querverbinders 33 geschlossen werden. Damit die Tiefe stets zuverlässig ermittelt werden kann, wird der Sensor 70 regelmässig kalibriert. Dazu können Kontrollmessungen an bearbeiteten Solarpanels 1 und/oder Messungen an vorgegebenen Mustern herangezogen werden. Die Messung wird für alle vier Kontaktbereiche 35 wiederholt, so dass vier Querpositionen und vier Tiefen ermittelt werden. Nach Bestimmung der vier seitlichen Positionen wird ein mittlerer Wert bestimmt, welcher es später erlaubt, das Kontaktviereck derart zu positionieren, dass sämtliche Querverbinder 33 zuverlässig kontaktiert werden können. Die gemessenen Werte werden für den nächsten Verfahrensschritt gespeichert.

Die Figur 4 zeigt eine schematische Querschnittsdarstellung der Freilegung eines Kontaktbereichs. Dazu wird ein an einem an sich bekannten Frässpindelsupport einer Fräseinrichtung 160 befestigtes Fräswerkzeug 80 an der vorher bestimmten Position durch die Rückseitenfolie 50 und die hintere Kunststoffschicht 40 hindurch bis auf den Querverbinder 33 geführt, wobei die erwähnten Schichten sowie die Zinnschicht des Querverbinders 33 in diesem Bereich abgetragen werden. Durch die Doppelung der Querverbinder 33 in deren Endbereich ist sichergestellt, dass auch nach dem vollständigen Abtragen der Zinnschicht ein ausreichender Querschnitt für die Leitung der zu erwartenden Ströme zur Verfügung steht. Im dargestellten Ausführungsbeispiel handelt es sich beim Fräswerkzeug 80 um einen HSS-Zweischneider, der mit hoher Drehzahl betrieben wird. Das Fräswerkzeug 80 ist derart ausgebildet, dass möglichst kurze Späne gebildet werden.

Während des Fräsvorgangs wird die Bearbeitungsstelle mit Luft gekühlt. Die Frästiefe ist - in Abhängigkeit der gemessenen Tiefe der Kontaktstelle - derart gewählt, dass die Zinnschicht des Querverbinders 33 sicher abgetragen wird, dass aber der verbleibende Querschnitt des in diesem Abschnitt gedoppelten Querverbinders 33 weiterhin ausreicht, um den zu erwartenden Maximalstrom zu führen. Die vier Frässtellen weisen eine feste geometrische Zuordnung zueinander auf, das Kontaktviereck wird gemäss den im vorherigen Schritt durchgeführten Messungen relativ zum Solarpanel 1 positioniert.

Die Figur 5 ist eine schematische Querschnittsdarstellung des nun freigelegten Kontaktbereichs 35.

Die Figur 6 zeigt eine schematische Querschnittsdarstellung der Kontaktierung des Kontaktbereichs 35 in einer entsprechenden Station 170. Die Figur 7 zeigt eine schematische Draufsicht auf die Rückseite des Solarpanels und der Anschlussdose. Nach dem Freilegen der Kontaktbereiche 35, 35.1...35.4 werden federnde Anschlussfahnen 90, 90.1...90.4 mit ihrem freien, ins Horizontale abgeknickten Ende an die Kontaktbereiche 35, 35.1...35.4 geführt. Das freie Ende kann anschliessend mit dem Kontaktbereich 35, 35.1...35.4 verlötet werden. Die freien Enden der Anschlussfahnen 90, 90.1...90.4 sind in einer von hinten nach vorne durchgehenden Öffnung 61 der Anschlussdose 60 positioniert, so dass das Lötwerkzeug von hinten durch diese Öffnung 61 hindurch auf die Anschlussfahnen 90, 90.1...90.4 zugreifen kann. Nach erfolgter Verlötung aller vier Anschlussfahnen 90, 90.1...90.4 kann die Öffnung 61 mit einem geeigneten Vergussmittel vergossen werden.

Die Erfindung ist nicht auf das dargestellte Ausführungsbeispiel beschränkt. So kann das Layout der Solarzellen, der Verbinder und der Kontaktflächen beispielsweise anders gewählt werden. Auch die erwähnten Materialien verstehen sich lediglich als Ausführungsbeispiele, z. B. sind anstelle der Schichten aus EVA auch andere Materialien einsetzbar, z. B. Silikongummi. Die Rückseitenkaschierung kann auch aus einem anderen Material, z. B. aus Polyvinylfluorid (Tedlar) hergestellt werden. Auch das Grundsubstrat muss keine Glasplatte sein, sondern kann z. B. aus einem Kunststoffmaterial gefertigt werden. Die Erfindung ist im Zusammenhang mit den meisten handelsüblichen Solarzellen anwendbar, insbesondere sowohl mit mono- als auch mit polykristallinen Zellen.

Anstelle einer Dopplung der freien Enden der Querverbinder können Querverbinder mit etwas vergrössertem Querschnitt eingesetzt werden, so dass auch nach der Freilegung des Kontaktbereichs ein ausreichender Querschnitt für die Leitung der maximal zu erwartenden Ströme vorhanden ist. Anstelle einer Lötverbindung zwischen den Anschlussfahnen und den Kontaktbereichen der Querverbinder kann auch eine Schweissverbindung geschaffen oder ein an sich bekanntes Verfahren zum Drahtbonden eingesetzt werden.

Auch die Anschlussdose kann anders ausgeführt sein, beispielweise können die Kontaktelemente durch über Schraubenfedern gelagerte Kontaktstücke gebildet werden oder der (Initial-)Kontakt wird nicht über Federn hergestellt, sondern erst während des Verbindungsvorgangs durch das externe Werkzeug.

Zusammenfassend ist festzustellen, dass durch die Erfindung ein Verfahren zur Herstellung einer Kontaktierung von Solarzellen geschaffen wird, welches automatisierbar ist und eine geringere Fehleranfälligkeit aufweist.

## Patentansprüche

1. Verfahren zur Herstellung einer Kontaktierung von in einem laminierten Solarpanel (1) angeordneten Solarzellen (30), wobei die Solarzellen (30) beidseitig ihrer Hauptflächen von je mindestens einer Schicht (10, 20, 40, 50) überdeckt sind, umfassend folgende Schritte:
a) vor einem Laminationsschritt Verbinden der Solarzellen (30) durch elektrisch leitende Verbinder (31, 33);
b) wobei die elektrisch leitenden Verbinder (31, 33) derart in das zu laminierende Solarpanel eingebracht werden, dass sie nach dem Laminationsschritt vollständig im Solarpanel (1) einlaminiert sind;
c) nach dem Laminationsschritt Freilegen eines Kontaktbereichs (35) der elektrisch leitenden Verbinder (33), indem mindestens eine der die Solarzellen überdeckenden Schichten (40, 50) in einem entsprechenden Bereich vollständig durchstossen, insbesondere abgetragen, wird; und
d) Kontaktieren des Kontaktbereichs (35) der elektrisch leitenden Verbinder (33) mittels eines von aussen abgreifbaren Anschlusselements (90).

2. Verfahren nach Anspruch 1, **dadurch gekennzeichnet, dass** vor dem Freilegen des Kontaktbereichs (35) eine Position der elektrisch leitenden Verbinder (33), insbesondere eine Lage und eine Tiefe, gemessen wird.

3. Verfahren nach Anspruch 2, **dadurch gekennzeichnet, dass** die Messung mittels eines induktiven Sensors (70) vorgenommen wird.

4. Verfahren nach einem der Ansprüche 1 bis 3, **dadurch gekennzeichnet, dass** das Freilegen des Kontaktbereichs (35) durch Fräsen erfolgt.

5. Verfahren nach einem der Ansprüche 1 bis 4, **dadurch gekennzeichnet, dass** die elektrisch leitenden Verbinder (31, 33) derart angeordnet werden, dass alle Kontaktbereiche (35) in einem Randbereich des Solarpanels (1) und insbesondere benachbart zueinander zu liegen kommen.

6. Verfahren nach Anspruch 5, **dadurch gekennzeichnet, dass** die elektrisch leitenden Verbinder (33) im Bereich der Kontaktbereiche (35) auf einem zusätzlichen gemeinsamen Träger (34) angeordnet werden.

7. Verfahren nach einem der Ansprüche 1 bis 6, **dadurch gekennzeichnet, dass** die Solarzellen (30) mittels Längsverbindern (31) miteinander zu Strängen (32) verbunden werden und dass verschiedene der Stränge (32) mittels Querverbinder (33) elektrisch verbunden werden, wobei die Kontaktbereiche (35) an den Querverbindern (33) ausgebildet sind.

8. Verfahren nach Anspruch 7, **dadurch gekennzeichnet, dass** das Verbinden der Längsverbinder (31) mit dem Querverbinder (33) und/oder das Kontaktieren des Kontaktbereichs (35) der elektrisch leitenden Verbinder (33) durch das von aussen abgreifbare Anschlusselement (90) durch eine fluxfreie Verbindung erfolgt.

9. Verfahren nach einem der Ansprüche 1 bis 8, **dadurch gekennzeichnet, dass** das von aussen abgreifbare Anschlusselement (90) in einer Anschlussdose (60) angeordnet ist, wobei die Anschlussdose (60) zum Kontaktieren des Kontaktbereichs (35) der elektrisch leitenden Verbinder (33) mit einer ersten Hauptfläche auf eine Rückseite des laminierten Solarpanels (1) aufgebracht wird.

10. Verfahren nach Anspruch 9, **dadurch gekennzeichnet, dass** das Anschlusselement (90) mit einem ersten Ende an der Anschlussdose (60) befestigt ist und dass das Anschlusselement (90) mit seinem zweiten, freien Ende federnd ausgeführt ist, so dass das federnde Ende nach dem Aufbringen der Anschlussdose (60) den Kontaktbereich (35) kontaktiert, wobei anschliessend das federnde Ende mit dem Kontaktbereich (35) verbunden, insbesondere verschweisst oder verlötet, wird.

11. Verfahren nach Anspruch 10, **dadurch gekennzeichnet, dass** das Anschlusselement (90) im Bereich einer durchgehenden Öffnung (61) der Anschlussdose (60) angeordnet ist, so dass zum Verbinden des Anschlusselements (90) mit dem Kontaktbereich (35) ein Verbindungswerkzeug von einer Rückseite an das Anschlusselement (90) herangeführt werden kann, wobei bevorzugt die Öffnung (61) nach dem Aufsetzen der Anschlussdose (60) und dem Verbinden des freien Endes mit dem Kontaktbereich (35) vergossen wird.

12. Verfahren nach einem der Ansprüche 1 bis 11, **dadurch gekennzeichnet, dass** die elektrisch leitenden Verbinder (33) zumindest im Kontaktbereich (35) bandartig sind, wobei sie im Wesentlichen flach zwischen die Schichten (20, 40) des Solarpanels (1) eingebracht werden.

13. Verfahren zur Herstellung von Solarpanels (1), umfassend folgende Schritte:
a) Bereitstellen eines Grundsubstrats (10), insbesondere einer Glasplatte;
b) Aufbringen einer ersten Laminierfolie (20) auf das Grundsubstrat (10), insbesondere einer Folie aus EVA;
c) Verbinden einer Mehrzahl von Solarzellen (30) mittels elektrisch leitenden Verbindern (31, 33);
d) Aufbringen der Solarzellen (30) auf die erste Laminierfolie (20);
e) Aufbringen einer zweiten Laminierfolie (40) auf die Solarzellen (30), insbesondere einer Folie aus EVA;
f) Aufbringen einer Rückseitenschicht (50) auf die zweite Laminierfolie (40) zur Herstellung des noch unlaminierten Solarpanels;
g) Laminieren der unlaminierten Solarpanels;
h) Freilegen eines Kontaktbereichs (35) der elektrisch leitenden Verbinder (33), indem die Rückseitenschicht (50) und die aus der zweiten Laminierfolie (40) entstandene Verbindungsschicht in einem entsprechenden Bereich vollständig durchstossen, insbesondere abgetragen, wird;
i) Kontaktieren des Kontaktbereichs (35) der elektrisch leitenden Verbinder (33) mittels eines von aussen abgreifbaren Anschlusselements (90).

14. Verfahren nach Anspruch 13, **dadurch gekennzeichnet, dass** das Verbinden der Mehrzahl von Solarzellen (30) mittels elektrisch leitenden Verbindern (31, 33) vor dem Aufbringen der Solarzellen (30) auf die erste Laminierfolie (20) erfolgt.

15. Solarpanel (1), umfassend mindestens zwei Schichten (10, 20, 40, 50), welche eine Mehrzahl von Solarzellen (30) beidseitig ihrer Hauptflächen einschliessen, wobei
a) die Schichten (10, 20, 40, 50) und die Solarzellen (30) zusammenlaminiert sind;
b) die Solarzellen (30) durch vollständig innerhalb der Schichten befindliche elektrisch leitende Verbinder (31, 33) miteinander verbunden sind;
c) die elektrisch leitenden Verbinder (31, 33) einen innerhalb der Schichten befindlichen Kontaktbereich (35) umfassen;
d) ein Zugang zum Kontaktbereich (35) vorhanden ist, welcher mindestens eine den Kontaktbereich (35) überdeckende Schicht (40, 50) durchquert;
e) ein von aussen abgreifbares Anschlusselement (90) durch den Zugang geführt und im Kontaktbereich (35) des Verbinders (33) mit diesem elektrisch verbunden, insbesondere verschweisst oder verlötet, ist.

16. Anlage zur Herstellung von laminierten Solarpanels (1), umfassend
a) eine Station (110) zum Verbinden von Solarzellen (30) durch elektrisch leitende Verbinder (31, 33);
b) eine Station (130) zum Aufbauen eines zu laminierenden Solarpanels (1), wobei die Solarzellen (30) und die elektrisch leitenden Verbinder (31, 33) beidseitig ihrer Hauptflächen von je mindestens einer Schicht (10, 20, 40, 50) überdeckt werden;
c) eine Einrichtung (140) zum Laminieren des Solarpanels (1);
d) eine Einrichtung (160), insbesondere eine Fräsmaschine, zum Freilegen eines Kontaktbereichs (35) der im Solarpanel (1) einlaminierten elektrischen Verbinder (31, 33), indem mindestens eine der die Solarzellen überdeckenden Schichten (40, 50) in einem entsprechenden Bereich vollständig durchstossen, insbesondere abgetragen, wird; und
e) eine Einrichtung (170), insbesondere eine Löt- oder Schweissstation, zum Kontaktieren des Kontaktbereichs (35) der elektrisch leitenden Verbinder (31, 33) mittels eines von aussen abgreifbaren Anschlusselements (90).

17. Anlage nach Anspruch 16, **gekennzeichnet durch** eine im Ablauf vor der Einrichtung zum Freilegen des Kontaktbereichs (35) angeordnete Einrichtung (150, 70) zum Messen einer Position der elektrisch leitenden Verbinder (33).
